# EUROPÄISCHE PATENTSCHRIFT

(11) **EP 3 285 032 B1**
(45) Veröffentlichungstag und Bekanntmachung des Hinweises auf die Patenterteilung: **24.07.2019**
(21) Anmeldenummer: 17186651.0
(22) Anmeldetag: 17.08.2017
(51) Int. Cl.: F25D 19/00, F17C 3/08, G01R 33/3815, H01F 6/04

(54) **KRYOSTATANORDNUNG UND VERFAHREN ZUM BETRIEB DAVON**
CRYOSTAT ARRANGEMENT AND METHOD OF OPERATION THEREOF
AGENCEMENT DE CRYOSTAT ET SON PROCÉDÉ DE FONCTIONNEMENT

(30) Priorität: 18.08.2016 DE 102016215518
(43) Veröffentlichungstag der Anmeldung: 21.02.2018
(73) Patentinhaber: Bruker BioSpin AG, 8117 Fällanden (CH)
(72) Erfinder: Wikus, Patrick, 8309 Nürensdorf (CH); Hinderer, Jörg, 79761 Waldshut-Tiengen (DE)
(74) Vertreter: Kohler Schmid Möbus Patentanwälte

(56) Entgegenhaltungen:
- EP-A1- 0 937 953
- DE-A1- 19 914 778
- DE-B3-102004 053 972
- DE-B4- 10 340 352
- US-A1- 2005 068 034

## Beschreibung

Die Erfindung betrifft eine Kryostatanordnung mit einem Vakuumbehälter, in welchem ein zu kühlendes supraleitendes Magnetspulensystem angeordnet ist, wobei ein Kryokühler vorhanden ist, der die Kryostatanordnung aktiv kühlt und einen Kühlmittelkreislauf mit einem Kompressor sowie einen Kühlkopf umfasst, welcher einen mindestens einstufigen, insbesondere zweistufigen Kühlarm aufweist, der in thermischem Kontakt mit dem supraleitenden Magnetspulensystem steht, wobei ein Volumengefäß mit kryogenem Medium, insbesondere mit Helium, so angeordnet ist, dass es thermisch leitend mit dem supraleitenden Magnetspulensystem und/oder mit Teilen der Kryostatanordnung verbunden ist, über welche Umgebungswärme auf das supraleitende Magnetspulensystem fließen kann.

Solche Kryostatanordnungen, die zum Teil allerdings immer noch geringe Mengen an flüssigem Kryogen enthalten können, sind an sich bekannt, etwa aus EP 0 937 953 A1, DE199 14 778 B4, DE 10 2014 218 773 A1, US 7,263,839 B2 oder auch aus US-A 5,410,286 (siehe Referenzen [1] bis [5]).

### Hintergrund der Erfindung

Das Einsatzgebiet der vorliegenden Erfindung bildet ein kryogenes System zur Kühlung eines supraleitenden Magnetspulensystems, wie es beispielsweise für Anwendungen bei Magnetresonanzverfahren, insbesondere für die Magnetresonanzspektroskopie (=NMR) oder die Magnetresonanztomographie (=MRI) eingesetzt wird. Die Anwendbarkeit der Erfindung ist jedoch nicht auf dieses Gebiet beschränkt.

Kernspinresonanz(=NMR)-Apparaturen, insbesondere NMR-Spektrometer und NMR-Tomographen, benötigen starke Magnetfelder, die oftmals mittels supraleitender Magnetspulen erzeugt werden. Die supraleitenden Magnetspulen müssen auf einer kryogenen Temperatur betrieben werden, um funktionsfähig zu sein.

Die Magnetspulen sind dafür typischerweise in einem Kryobehälter eines Kryostaten angeordnet, welcher bei den klassischen, "nicht-trockenen" mit einer kryogenen Flüssigkeit, insbesondere flüssigem Helium, befüllt ist, wie etwa in DE 10 2004 053 972 B3 (=Referenz [7]) beschrieben. Um langfristig die Betriebstemperatur aufrecht zu erhalten und dabei den Verbrauch von kryogenen Flüssigkeiten möglichst klein zu halten, ragt der Kühlarm eines Kaltkopfs in den Kryobehälter, mit dem Wärme entzogen werden kann. Der Kryobehälter ist zur thermischen Isolation von einem Vakuumbehälter umgeben. Bei der Anordnung nach Referenz [7] dient der Kaltkopf allerdings nicht in erster Linie der Kühlung des Heliumtanks, sondern vor allem der Kühlung eines NMR-Probenkopfes.

Viele Anwender bevorzugen allerdings "kryogenfreie" Magnete, die weitgehend auf den Einsatz von kryogenen Flüssigkeiten (z.B. flüssiges Helium und/oder flüssigen Stickstoff) verzichten, und die Betriebstemperatur ausschließlich mit sogenannten "Kryokühlern", also "trocken" aufrechterhalten. Typischerweise kommen hier Pulsrohr-, Stirling- oder Gifford-McMahonkühler zum Einsatz.

Der Nachteil eines solchen kryogenfreien Magnetsystems besteht in der teilweise sehr kurzen "Time-to-Quench" (abgekürzt "TTQ"). Bei einem Ausfall des Kryokühlers (üblicherweise bedingt durch einen Stromausfall, eine Unterbrechung in der Kühlwasserversorgung oder einen mechanischen Defekt am Kompressor oder Kaltkopf) wärmt sich das Magnetsystem sehr schnell über die zulässige Betriebstemperatur auf, die Supraleitung bricht zusammen und das System quencht. Das Magnetsystem ist dann für längere Zeit nicht mehr benutzbar, da es wieder abgekühlt und neu geladen werden muss.

Dafür müssen separate Systeme zum automatischen Befüllen des Reservoirs nach einem Ausfall des aktiven Kühlers vorgesehen werden. Bisher sind Lösungen bekannt geworden, in denen eine Gasflasche, die üblicherweise mit Helium befüllt ist, verwendet wird. Nach einer gewissen Anzahl von Kühlerausfällen ist die Gasflasche dann allerdings leer und muss ersetzt werden.

Eine weitere Möglichkeit besteht darin, das Reservoir mit einem Speichervolumen zu verbinden, in das das Kryogen abströmen kann (das Speichervolumen hat typischerweise Raumtemperatur). Das Speichervolumen muss typischerweise sehr groß ausgeführt werden, um einen unzulässig hohen Druckanstieg zu vermeiden.

Eine weitere Möglichkeit schließlich besteht darin, das Heliumreservoir und - falls vorhanden - das Speichervolumen hermetisch dicht und mechanisch sehr stabil auszuführen, sodass es den enormen Drücken standhält, die sich beim Verdampfen und Erwärmen von Helium in einem kleinen geschlossenen Volumen aufbauen. Ein solches Reservoir ist zwar kompakt, hat jedoch ein sehr hohes Gewicht und ist zudem relativ kostspielig. Besonders nachteilig ist, dass der Druck im warmen Zustand am höchsten ist, und im Betrieb absinkt, d.h. das Reservoir ist für die im Normalbetrieb herrschenden Drücke überdimensioniert.

### Spezifischer Stand der Technik

Nach der eingangs zitierten EP 0 937 953 A1 (Referenz [1]) wird die TTQ verlängert, indem kleine Mengen eines Kryogens in einem dafür vorgesehenen Reservoir bevorratet werden. Die beschriebene Vorrichtung leidet jedoch daran, dass das Speichervolumen sehr groß ausgeführt werden muss (1200 Liter im praktischen Beispiel in Referenz [1]).

Auch bei der Kryostatanordnung nach der DE 199 14 778 B4 (Referenz [2]) wird die TTQ dadurch verlängert, dass kleine Mengen eines Kryogens in einem dafür vorgesehenen Reservoir bevorratet werden.

Das Reservoir ist auch hier mit einem separaten Speichervolumen verbunden, das sehr groß ausgeführt werden muss.

DE 10 2014 218 773 A1 (Referenz [3]): Auch diese Anordnung hat die Verlängerung der TTQ zum Ziel. Es wird dort allerdings ein gänzlich anderer Ansatz verfolgt: Anstatt die Wärmekapazität bzw. die zu Verfügung stehende Wärmekapazität zu erhöhen, wird bei einem Ausfall des aktiven Kühlers die thermische Kopplung zwischen Spule und Kühler reduziert.

US 7,263,839 B2 (Referenz [4]): Dieses Dokument beschreibt etwas flüssiges Helium in einem kryogenfreien System vorzusehen, um die TTQ zu verlängern. Der Gaskreislauf des aktiven Kühlers wird hier allerdings nicht zur Verlängerung der TTQ verwendet, was in einer der beschriebenen Ausführungsformen einen separaten Kompressor nötig macht und die Komplexität des Systems deshalb erhöht.

US-A 5,410,286 (Referenz [5]): Auch hier wird wieder mit einer geringen Menge an flüssigem Helium in einem ansonsten "trockenen" System gearbeitet. Der Gaskreislauf des aktiven Kühlers wird hier ebenfalls nicht zur Verlängerung der TTQ verwendet. In den beschriebenen Ausführungsformen entweicht das Kryogen vielmehr in die Atmosphäre.

WO-2016/038093 A1 (Referenz [6]): Die TTQ wird bei diesem Stand der Technik dadurch verlängert, dass ein Reservoir mit einem Kryogen vorgesehen wird. Hier ist das Reservoir aber komplett hermetisch ausgeführt. Bei seiner Erwärmung baut sich im Inneren ein extrem hoher Druck auf. Das Reservoir muss deshalb entsprechend stabil (und deshalb groß, schwer und teuer) ausgeführt werden.

### Aufgabe der Erfindung

Der vorliegenden Erfindung liegt demgegenüber die Aufgabe zugrunde, eine "trockene", zumindest "quasi-trockene", Kryostatanordnung der eingangs beschriebenen Art mit einem supraleitenden Magnetspulensystem mit möglichst einfachen technischen Mitteln dahingehend zu verbessern, dass die oben diskutierten Nachteile bekannter gattungsgemäßer Anordnungen vermieden werden. Insbesondere soll die Kryostatanordnung bei eventuellen Betriebsstörungen eine ausreichend lange "Time-to-Quench" ermöglichen, und gleichzeitig einfach und zuverlässig im Aufbau, weitgehend wartungsfrei (kein Nachfüllen von Helium) und billig in der Herstellung sein.

### Kurze Beschreibung der Erfindung

Diese Aufgabe wird erfindungsgemäß auf ebenso überraschend einfache wie wirkungsvolle Weise sowie mit ohne Weiteres und kostengünstig zur Verfügung stehenden technischen Mitteln dadurch gelöst, dass das Volumengefäß zwischen 0,5 und 5 Liter fasst, dass das Volumengefäß über eine druckfeste Leitung, die zumindest teilweise durch den Vakuumbehälter geführt ist, mit dem Kühlmittelkreislauf des Kryokühlers verbunden ist, dass in der druckfesten Leitung mindestens ein strömungstechnisches Bauelement, welches ein Drosselelement, ein Auf-Zu-Ventil oder ein Regelventil umfasst, angeordnet ist, mittels welchem die Durchflussmenge an kryogenem Medium durch die druckfeste Leitung definiert beeinflusst werden kann, und dass das strömungstechnische Bauelement derart ausgestaltet ist, dass es die Durchflussmenge des durch eine Druckdifferenz zwischen dem Volumengefäß und dem Kühlmittelkreislauf des Kryokühlers hervorgerufenen Volumenstroms derart beeinflusst, dass entweder das kryogene Medium aus dem Kühlmittelkreislauf des Kryokühlers das Volumengefäß mit einer Zeitkonstanten von mindestens 15min befüllt oder dass das kryogene Medium aus dem Volumengefäß mit einer Zeitkonstanten von mindestens 15min in den Kühlmittelkreislauf des Kryokühlers abströmt.

### Genaue Wirkungsweise der Erfindung und weitere Vorteile gegenüber dem Stand der Technik

Die vorliegende Erfindung schlägt also eine Kryostatanordnung vor, welche es ermöglicht, eine supraleitende Magnetanordnung wirklich "trocken" zu betreiben, also ohne Zufuhr von kryogenen Fluiden auf einer kryogenen Betriebstemperatur zu halten, und diese Betriebstemperatur auch im Falle des Versagen der aktiven Kühlung für eine signifikante Zeitdauer aufrechtzuerhalten (Verlängerung der "Time-to-Quench").

Zur effektiven Verlängerung der TTQ macht sich die Erfindung dabei den ohnehin grundsätzlich immer bei derartigen Systemen vorhandenen, außerhalb des Vakuumbehälters des Kryostaten angeordneten Kühlmittelkreislauf des Kryokühlers zunutze, indem sie das Volumengefäß über eine druckfeste Leitung, die zumindest teilweise durch den Vakuumbehälter geführt ist, mit dem Kühlmittelkreislauf des Kryokühlers verbindet. Die Größe eines Fluid-Flusses durch die druckfeste Leitung wird durch ein strömungstechnisches Bauelement bestimmt.

### Bevorzugte Ausführungsformen der Erfindung

Ganz besonders bevorzugt sind Ausführungsformen der Erfindung, bei denen das strömungstechnische Bauelement derart aufgebaut und so angeordnet ist, dass die Zeitkonstante für das Befüllen oder das Entleeren des Volumengefäßes mindestens 1h, vorzugsweise mehr als 3h beträgt. Damit wird die Autonomiezeit des Systems zwischen Stromausfall und Quench lange genug gemacht, um den Löwenanteil der Stromausfälle z.B. in Europa, Nordamerika oder Fernost zu überbrücken.

Weitere Ausführungsformen zeichnen sich dadurch aus, dass die Kryostatanordnung Temperatursensoren und/oder Drucksensoren umfasst.

Bei einer Klasse von Ausführungsformen umfasst das strömungstechnische Bauelement ein passives Drosselelement. Dies ist die simpelste Ausführungsform, hat das kleinste technische Risiko, ist sehr zuverlässig und sehr kostengünstig.

Eine alternative Klasse von Ausführungsformen ist dadurch gekennzeichnet, dass das strömungstechnische Bauelement ein Auf-Zu-Ventil und eine elektronische Regeleinrichtung für dieses Auf-Zu-Ventil umfasst, wobei die Ausgangssignale der Temperatur- und/oder Drucksensoren zur Regelung des Auf-Zu-Ventils verwendet werden. Gegenüber der Verwendung einer bloßen Drossel wird die TTQ hierdurch weiter verlängert, da das Kryogen nun "kontrolliert" im richtigen Zeitpunkt "geopfert" wird. Man kühlt also dann und nur dann, wenn man es wirklich braucht, und senkt so die Heliumverbrauchsrate und damit einen großen Kostenanteil.

Bei einer weiteren alternativen Klasse von Ausführungsformen umfasst das strömungstechnische Bauelement ein Regelventil und eine elektronische Regeleinrichtung für das Regelventil, wobei die Ausgangssignale der Temperatur- und/ oder Drucksensoren zur Regelung des Regelventils verwendet werden. Dies führt zu einer weiteren Effizienzsteigerung gegenüber dem Auf-Zu-Ventil.

Vorteilhafte Weiterbildungen der beiden letztgenannten Klassen von Ausführungsformen sind dadurch gekennzeichnet, dass die elektronische Regeleinrichtung an eine unterbrechungsfreie Stromversorgung angeschlossen ist. Die Vorrichtung zur Überbrückung eines Stromausfalls, die ja Gegenstand der vorliegenden Erfindung ist, macht mit Ausnahme der ungeregelten passiven Drossel nur dann wirklich Sinn, wenn diese Vorrichtung den Stromausfall ebenfalls "überlebt". In diesem Sinne ist eine solche unterbrechungsfreie Stromversorgung Voraussetzung für eine sichere Regelung bei Stromausfällen.

Bei weiteren vorteilhaften Ausführungsform der erfindungsgemäßen Kryostatanordnung kann mindestens eine Vorrichtung zur Messung des aktuellen Massendurchflusses durch die zum Volumengefäß führende druckfeste Leitung vorhanden sein, deren Ausgangssignale zur Regelung einer Ventileinrichtung im strömungstechnischen Bauelement verwendet werden. Die Daten des Strömungssensors erlauben eine noch besser adaptierte Regelung des Ventils, was zu weiterer Effizienzsteigerung führt.

Ganz besonders bevorzugt ist eine Klasse von Ausführungsformen der erfindungsgemäßen Kryostatanordnung, bei denen die druckfeste Leitung derart aufgebaut und so angeordnet ist, dass sie einen Wärmeaustausch des aus dem Volumengefäß in den Kühlmittelkreislauf des Kryokühlers abströmenden kryogenen Mediums mit Teilen des Kryostaten ermöglicht, über die ein Wärmeeintrag in das supraleitende Magnetspulensystem erfolgt, insbesondere mit dem Kühlkopf des Kryokühlers. Das abströmende Helium nimmt bei allen Temperaturen auf dem Weg nach oben Wärme auf. Würde man nur "ganz unten" koppeln, käme das Helium sehr kalt aus dem System und seine Wärmeaufnahmefähigkeit wäre nur sehr schlecht ausgenutzt worden. Das von unten kommende Helium sollte die von Raumtemperatur her einströmende Wärme möglichst adiabatisch aufnehmen, ähnlich einem Gegenstromwärmetauscher, um eine besonders hohe Effizienz zu erreichen.

Vorteilhafte Weiterbildungen dieser Klasse von Ausführungsformen sind dadurch gekennzeichnet, dass die druckfeste Leitung eine Rohrwendel umfasst, welche zumindest um Teile des Kühlarms herum angeordnet ist. Der Kühlarm ist ein wichtiges "Einfallstor", durch welches Wärme aus der Raumtemperatur-Umgebung auf das Magnetsystem einströmt. Diesen "im Gegenstrom" zu thermalisieren ist essentiell für die praktische Verwirklichung der vorliegenden Erfindung. Die Rohrwendel ermöglicht dies in einfacher und doch effizienter Form.

Weitere vorteilhafte Varianten zeichnen sich dadurch aus, dass das zu kühlende supraleitende Spulensystem innerhalb des Vakuumbehälters von einem Strahlungsschild umgeben ist, und dass die druckfeste Leitung mindestens einen Wärmetauscher umfasst, der mit dem Strahlungsschild und/ oder mit einer Stufe des Kühlarms in thermischem Kontakt steht. In Analogie zum vorhergehenden Abschnitt ist auch der Strahlungsschild einer der besonders wichtigen zu kühlenden Systemteile. Das kommt neben der Wärmstrahlung daher, dass sehr oft auch ein Stromstab mit diesem Strahlungsschild in thermischem Kontakt steht, der ebenfalls ein "Haupteinfallstor" für Wärme darstellt.

Bei besonders einfachen Ausführungsformen der erfindungsgemäßen Kryostatanordnung ist strömungstechnisch parallel zum Kompressor eine Bypass-Drossel geschaltet, wie sie per se etwa durch die Anmelderin, beispielsweise aus der DE 103 40 352 B4 (=Referenz [8]), bekannt geworden ist. Diese Drossel erlaubt dem abströmenden Heliumgas, von der Hoch- auf die Niederdruckseite des Kühlmittelkreislaufes zu gelangen, auf der sich ein im übernächsten Abschnitt beschriebenes Puffervolumen befindet. Ohne die Bypass-Drossel würde die Hochdruckseite sich schnell mit etwas Gas füllen, einen Gegendruck aufbauen, und das Heliumgas könnte nicht mehr aus dem Volumengefäß abströmen.

In der Praxis bewähren sich auch Ausführungsformen der Erfindung, bei denen das Volumengefäß etwa 1 bis 2 Liter, fasst. Diese Dimensionierung ist einerseits handlich und gut implementierbar, erlaubt aber andererseits ein Erreichen der von der vorliegenden Erfindung zu leistenden Verlängerung der TTQ.

Weitere vorteilhafte Ausführungsformen zeichnen sich dadurch aus, dass ein Puffervolumen, vorzugsweise mit einer Größe von etwa 100 Liter, im Kühlmittelkreislauf des Kryokühlers, insbesondere in einer Saugleitung zwischen dem Kühlkopf und dem Kompressor, angeordnet ist. Die Vorteile sind ähnlich, wie oben unter der Variante "Drossel plus Dimensionierung des Volumengefäßes" diskutiert. Die Dichten von Helium bei Raumtemperatur und bei 4K sowie jeweils hohen Drücken (überkritisch) bedeuten ein Dichteverhältnis von ca. 100. Daher gehört zu einem 1-Liter Volumengefäß in etwa ein 100-Liter-Tank.

Bevorzugt sind auch Ausführungsformen der erfindungsgemäßen Kryostatanordnung, die sich dadurch auszeichnen, dass die supraleitende Magnetanordnung HTS-Elemente umfasst. Der Vorteil beim Einsatz von HTS-Material liegt vor allem darin, dass sich entweder besonders hohe Felder erreichen lassen, oder der Magnet bei vergleichsweise hohen Temperaturen betrieben werden kann, was das Kühlsystem vereinfacht.

Ganz besonders bevorzugt sind auch Ausführungsformen der erfindungsgemäßen Kryostatanordnung, bei welchen die Kryostatanordnung Teil einer Magnetresonanz-Apparatur ist. Die erfindungsgemäße Kryostatanordnung kann zusammen mit der supraleitenden Magnetspule Teil eines Magnetsystems sein, das eine Feldstärke zwischen 2 und 20 Tesla erzeugen kann, insbesondere als Teil einer NMR-, MRI- oder FTMS-Apparatur.

In den Rahmen der vorliegenden Erfindung fällt auch ein Verfahren zum Betrieb einer erfindungsgemäßen Kryostatanordnung der oben beschriebenen Art, bei welcher mindestens eine Vorrichtung zur Messung des aktuellen Betriebszustands des Kompressors und/oder der aktuellen Temperatur des supraleitenden Magnetspulensystems und/oder des aktuellen Drucks in der zum Volumengefäß führenden druckfesten Leitung vorhanden ist, wobei das strömungstechnische Bauelement mit einer elektronischen Regeleinrichtung verbunden ist. Dieses Betriebsverfahren zeichnet sich dadurch aus, dass die elektronische Regeleinrichtung bei einer -insbesondere durch Stromausfall hervorgerufenen-Betriebsstörung des Kompressors des Kühlmittelkreislaufs und/oder bei einem Anstieg der aktuellen Temperatur des supraleitenden Magnetspulensystems während des Betriebs über eine festgelegte Maximaltemperatur und/oder bei einem Anstieg des aktuellen Drucks in der zum Volumengefäß führenden druckfesten Leitung über einen festgelegten Maximaldruck das strömungstechnische Bauelement derart ansteuert, dass kryogenes Medium aus dem Volumengefäß in den Kühlmittelkreislauf des Kryokühlers abströmt. In einer einfachen Ausführung wird dies durch eine einfache Einpunktregelung realisiert, in der das Ventil geöffnet bzw. geschlossen wird, je nachdem, ob ein gemessener Regelparameter kritisch ist oder nicht. Es sind aber auch andere Regelalgorithmen denkbar und sinnvoll. Hier sind z.B. eine Zweipunktregelung und eine Pulsweitenregelung im Falle des Auf-Zu-Ventils bzw. einer Proportionalregelung oder einer PID-Regelung für das Regelventil zu nennen.
Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Funktionsskizze einer ersten, möglichst einfach gehaltenen Ausführungsform der erfindungsgemäßen Kryostatanordnung als TCF(="true cryogen free")-Variante mit einem von Wärmetauschern der druckfesten Leitung umgebenen Kühlarm des Kühlkopfs;
- Fig. 2: wie Fig. 1, jedoch mit einem konkret als Drosselelement ausgeführten strömungstechnischen Bauelement;
- Fig. 3: wie Fig. 2, jedoch zusätzlich mit Temperatur- und Drucksensoren, einem Auf-Zu-Ventil als weiteres strömungstechnisches Bauelement sowie einer elektronischen Regeleinrichtung zur Ansteuerung der Ventile;
- Fig. 4: wie Fig. 3, jedoch mit einem als Regelventil ausgeführten strömungstechnischen Bauelement sowie zusätzlich mit einem Durchfluss-Sensor und einer unterbrechungsfreien Stromversorgung der elektronischen Regeleinrichtung; und
- Fig. 5: wie Fig. 4, jedoch mit einer GCT(="gas coupled technology")-Variante der erfindungsgemäßen Kryostatanordnung, wobei ein Aufnahmerohr des Kryokühlers im Vakuumbehälter mit einer Rohrwendel umgeben ist.

Der klassische Aufbau eines aktiv gekühlten Supraleitermagnetsystems besteht aus einem Supraleitermagneten ("magnet coil") in einem Isolationsvakuum, der durch die zweite Stufe eines Kryokühlers gekühlt wird. Die erste Stufe wird zur Kühlung eines Strahlungsschildes verwendet (hier nicht gezeigt). Dieser Kaltkopf ist an einen Kompressor angeschlossen, der im Betriebsfall Helium von ca. 5-10 bar auf 20-25 bar verdichtet. Dieses Helium treibt dann den Kaltkopf an.

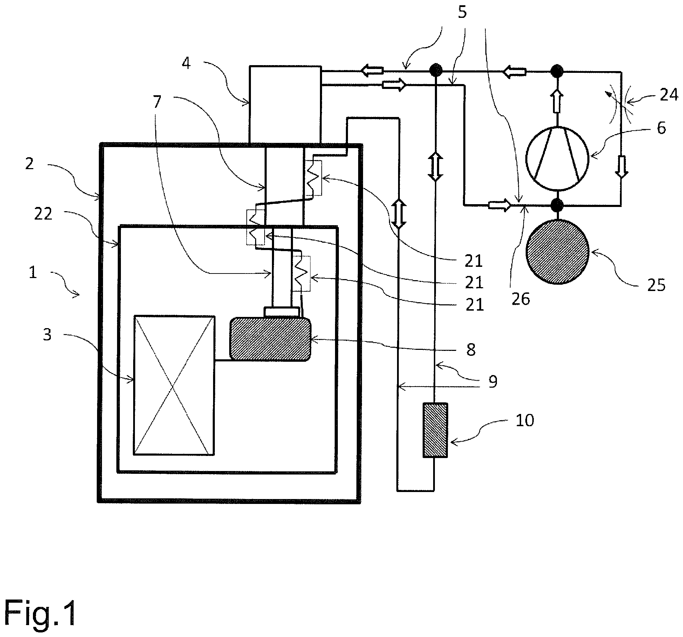

Wie in Fig. 1 dargestellt, ist bei einer derartigen **Kryostatanordnung 1** in einem **Vakuumbehälter 2** ein zu kühlendes supraleitendes **Magnetspulensystem 3** angeordnet, wobei ein Kryokühler vorhanden ist, der die Kryostatanordnung 1 aktiv kühlt und einen **Kühlmittelkreislauf 5** mit einem **Kompressor 6** sowie einen **Kühlkopf 4** umfasst, welcher einen -im dargestellten Ausführungsbeispiel zweistufigen- **Kühlarm 7** aufweist, der in thermischem Kontakt mit dem supraleitenden Magnetspulensystem 3 steht, wobei ein **Volumengefäß 8** mit kryogenem Medium, insbesondere mit Helium, so angeordnet ist, dass es thermisch leitend mit dem supraleitenden Magnetspulensystem 3 und mit Teilen der Kryostatanordnung 1 verbunden ist, über welche Umgebungswärme auf das supraleitende Magnetspulensystem fließen kann.

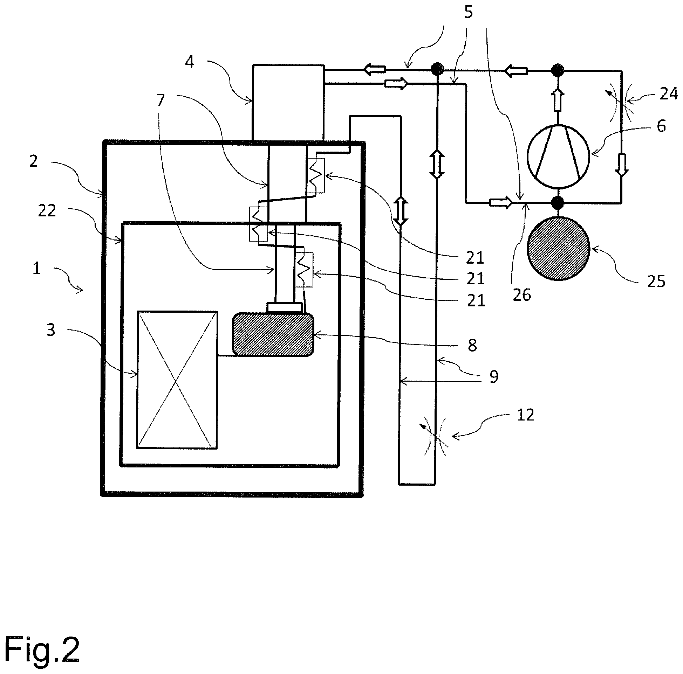

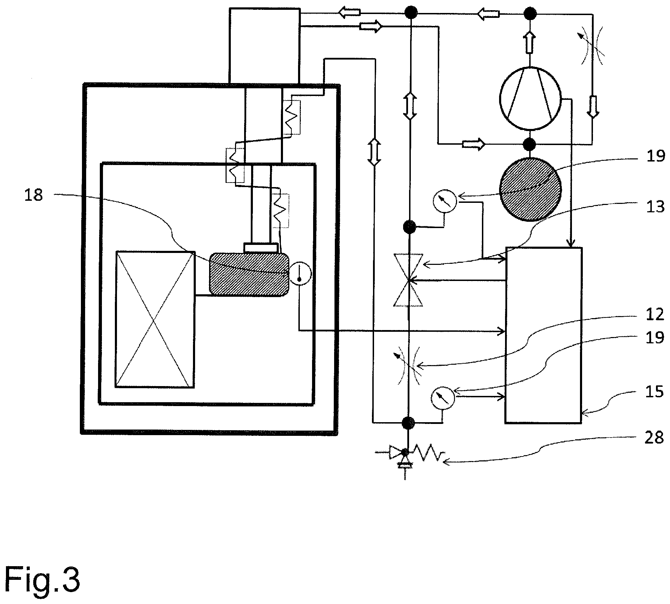

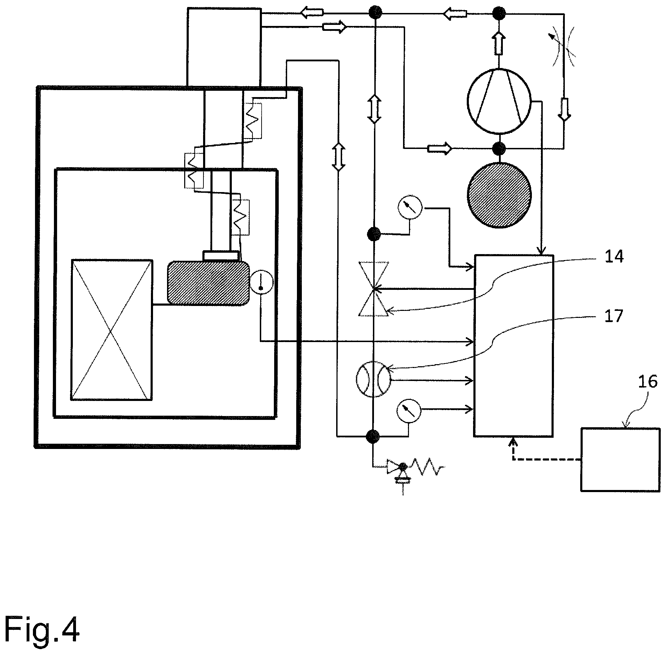

Die vorliegende Erfindung erweitert diese an sich bekannte Anordnung um folgende erfindungswesentlichen Elemente:
- Das Volumengefäß 8 ist über eine **druckfeste Leitung 9,** die zumindest teilweise durch den Vakuumbehälter 2 geführt ist, mit dem Kühlmittelkreislauf 5 des Kryokühlers verbunden und fasst in der Regel zwischen 0,5 und 5 Liter, vorzugsweise etwa 1 bis 2 Liter.
- In der druckfesten Leitung 9 ist mindestens ein **strömungstechnisches Bauelement 10** angeordnet, welches ein **Drosselelement 12** (siehe Fig. 2), ein **Auf-Zu-Ventil 13** (siehe Fig. 3) oder ein **Regelventil 14** (siehe Fig. 4) umfasst, mittels welchem die Durchflussmenge an kryogenem Medium durch die druckfeste Leitung 9 definiert beeinflusst werden kann.
- Das strömungstechnische Bauelement 10 ist derart ausgestaltet, dass es die Durchflussmenge des durch eine Druckdifferenz zwischen dem Volumengefäß 8 und dem Kühlmittelkreislauf 5 des Kryokühlers hervorgerufenen Volumenstroms derart beeinflusst, dass entweder das Volumengefäß 8 mit einer Zeitkonstanten von mindestens 15min mit kryogenem Medium aus dem Kühlmittelkreislauf 5 des Kryokühlers befüllt wird oder dass das kryogene Medium mit einer Zeitkonstanten von mindestens 15min aus dem Volumengefäß 8 in den Kühlmittelkreislauf 5 des Kryokühlers abströmt.

In der Regel wird das strömungstechnische Bauelement 10 derart aufgebaut und so angeordnet sein, dass die Zeitkonstante für das Befüllen oder das Entleeren des Volumengefäßes 8 mindestens 1h, vorzugsweise mehr als 3h beträgt.

Die druckfeste Leitung 9 wiederum wird derart aufgebaut und so angeordnet sein, dass sie einen Wärmeaustausch des aus dem Volumengefäß 8 in den Kühlmittelkreislauf 5 des Kryokühlers abströmenden kryogenen Mediums mit Teilen des Kryostaten ermöglicht, über die ein Wärmeeintrag in das supraleitende Magnetspulensystem 3 erfolgt, insbesondere mit dem Kühlkopf 4 des Kryokühlers.

Strömungstechnisch parallel zum Kompressor 6 wird normalerweise eine **Bypass-Drossel 24** geschaltet sein. Für diese Bypass-Drossel 24 ist wichtig, dass sie hochimpedant genug ist, um nicht den Kompressor 6 "kurzzuschließen", aber ausreichend niederimpedant, um den Rückfluss des Heliums bei Kompressorausfall in das Puffervolumen zu ermöglichen.

In einer alternativen Ausführungsform wird die Bypass-Drossel durch ein schaltbares Ventil ersetzt. Dieses Ventil kann z.B. als "NO" (normally open) ausgeführt werden, und einfach parallel zum Kompressor an die Stromversorgung angeschlossen sein. Im Falle eines Stromausfalles öffnet es sich, und das Helium kann zurück ins Puffervolumen fließen. Alternativ kann das Steuerventil auch an einen Steuerausgang des Kompressors oder sogar an einen Steuerausgang der elektronischen Regeleinheit 15 angeschlossen werden, was weitere Optimierung der Regelung erlauben kann. Die Ausführung mit Ventil statt Bypass-Drossel sorgt zudem zu einer Effizienzsteigerung, da der bei der Drossel auftretenden "Leckfluss" im Betriebszustand unterbunden wird.

Außerdem kann ein **Puffervolumen 25,** vorzugsweise mit einer Größe von etwa 100 Liter, im Kühlmittelkreislauf 5 des Kryokühlers, insbesondere in einer **Saugleitung 26** zwischen dem Kühlkopf 4 und dem Kompressor 6, angeordnet sein.

Das zu kühlende supraleitende Spulensystem 3 ist innerhalb des Vakuumbehälters 2 normalerweise von einem **Strahlungsschild 22** umgeben. Wie in den Figuren 1 bis 4 mit TCF-Varianten der erfindungsgemäßen Kryostatanordnung 1 gezeigt, kann die druckfeste Leitung 9 einen oder mehrere **Wärmetauscher 21** umfassen, der/die mit dem Strahlungsschild 22 und/ oder mit einer Stufe des Kühlarms 7 in thermischem Kontakt steht/stehen.

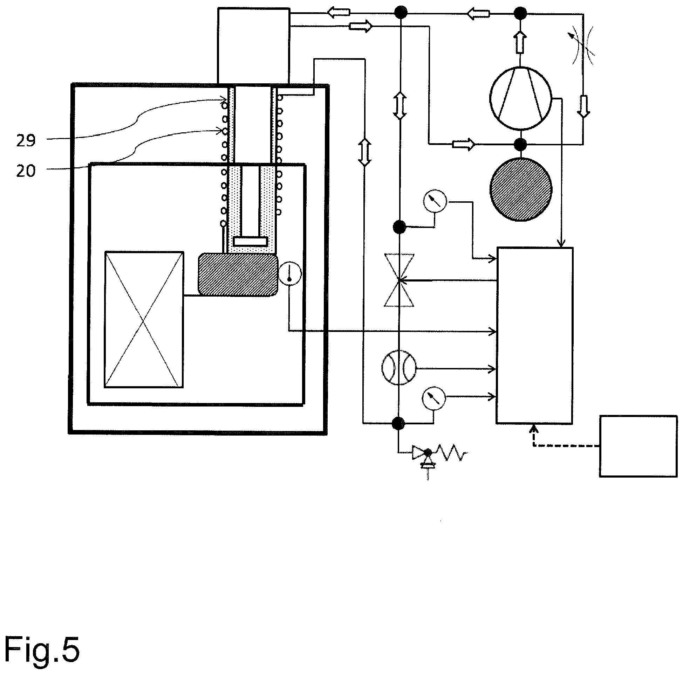

In Fig. 5 ist eine GCT-Variante der erfindungsgemäßen Kryostatanordnung 1 dargestellt, bei welcher die druckfeste Leitung 9 eine **Rohrwendel 20** umfasst, die zumindest um Teile des Kühlarms 7 herum -im gezeigten Ausführungsbeispiel um ein **Aufnahmerohr 29** des Kryokühlers- angeordnet ist.

Wie in den Figuren 3 bis 5 gezeigt, kann die erfindungsgemäße Kryostatanordnung 1 **Temperatursensoren 18** und/ oder **Drucksensoren 19** umfassen, deren Ausgangssignale in eine elektronische **Regeleinrichtung 15** zur Ansteuerung der Ventile eingespeist werden, welche an eine **unterbrechungsfreie Stromversorgung 16** angeschlossen sein kann, wie in den Figuren 4 und 5 dargestellt. Möglich ist auch der Einsatz eines **Durchfluss-Sensors 17.** Zur Absicherung gegen übermäßigen Druckaufbau kann in der druckfesten Leitung 9 auch ein **Sicherheitsventil 28** eingebaut sein.

In der in Fig. 2 dargestellten einfachsten Ausführungsform der Erfindung ist die druckfeste Leitung 9 im weiteren Verlauf über das Drosselelement 12 an die Hochdruckseite des Kaltkopf-Heliumkompressors 6 angeschlossen. Die Drossel muss dabei so ausgelegt sein, dass der Heliumstrom bei geöffnetem Ventil sowohl beim Befüllen als auch beim Entleeren des Hochdruckvolumens in wohldefinierter Geschwindigkeit abläuft, z.B. während einiger Stunden. Damit wird einerseits beim Befüllen verhindert, dass zu schnell heißes Gas Richtung Magnet strömt (Quenchgefahr), und beim Entleeren wird hierdurch die Zeitskala der TTQ-Verlängerung bzw. die Kühlleistung definiert. Außerdem ist in der Saugleitung 26 des Kompressors 6 ein Puffervolumen 25 (wie bereits oben erwähnt mit einer Größe von etwa 100 Liter) vorgesehen.

Im Folgenden werden die einzelnen Betriebszustände der oben gezeigten Anordnung beschrieben:
1.- Ruhezustand (z.B. bei Anlieferung des Systems): Alle Volumina sind bei Raumtemperatur und beim statischen (mittleren) Druck von ca. 15bar, inklusive dem Puffervolumen 25 und dem Tieftemperatur-Druckreservoir (Volumengefäß 8)
2.- Abkühlen: Der Kompressor 6 startet und bringt die Unterdruckseite auf z.B. 5bar, und die Überdruckseite auf z.B. 25bar. Während der Kühler den Magneten abkühlt, wird ein Teil des Gases von der Hochdruckseite durch die Drossel sukzessive in das Volumen eingekühlt, bis es schließlich am Ende des Abkühlvorganges mit einer Dichte von ca. 160g/l bei ca. 25bar bei 4,2K im überkritischen Zustand ins zeitliche Gleichgewicht kommt. Das Gas hat hierbei über den gesamten Temperaturbereich von 300K bis hinunter zu 4K kontinuierlich Wärme an den Kaltkopf abgegeben, die spezifische Wärme liegt überall im Bereich von Cp=5/2R, also ca. 20J/ mol K. Bei 300K Temperaturhub, und ca. 40 Mol pro Liter (1 Mol = 4g) und einem 1 Liter großen Volumengefäß 8 ergibt sich so eine Wärmeabsorptionskapazität von über 200kJ. Das Puffervolumen 5 stellt das Gas zu Verfügung, das in das Volumengefäß 8 einkondensiert.
3.- Normalbetrieb: Druckschwankungen an der Hochdruckseite (aufgrund des Arbeitszyklus des Kaltkopfes 4) pflanzen sich ins Volumengefäß 8 weiter und führen zu einer zusätzlichen Wärmelast. Die Drossel schwächt die Druckschwankungen im Volumengefäß 8 allerdings ausreichend ab.
4.- Stromausfall: Der Kompressor 6 stoppt, der Kaltkopf 4 kühlt nicht mehr, Wärme strömt durch verschiedene Pfade in das System ein (z.B. durch Aufhängungen, den Stromstab, den Kaltkopf selbst). Das im Volumengefäß 8 befindliche Kryogen strömt durch Wendel und Drossel ab und nimmt dabei Wärme auf, d.h. die "Time-to-Quench" verlängert sich entsprechend. Auf dem Weg nach oben nimmt das Helium in der Wendel noch viel einströmende Wärme auf, so dass es im Idealfall den Turm mit annähernd Raumtemperatur verlässt. Hinter der Drossel herrscht übrigens während des Stromausfalls der statische Druck von ca. 15bar. Das wird entweder durch eine Bypass-Drossel 24 sichergestellt, die parallel zum Kompressor angeordnet ist, oder durch ein elektrisch gesteuertes Ventil an derselben Stelle.
5.- Recovery: Strom kommt zurück, der Kompressor 6 springt wieder an, der Kaltkopf 4 kühlt wieder. Eine Gasdruckdifferenz über den Kompressor 6 baut sich wieder auf, dadurch wird das Druckvolumen über die Drossel langsam wieder mit Heliumgas befüllt.

Eine weitere mögliche Ausbildungsform sieht ein Elektroventil (Auf-Zu-Ventil 13) vor, mit dem eine aktive Steuerung möglich wird. Das Elektroventil kann mit der Drossel in Serie geschaltet werden, um ein sanfteres Ansprechen zu erreichen:
Das Elektroventil ist seinerseits durch die elektronische Regeleinrichtung 15 angesteuert, die den Schaltzustand (offen/ geschlossen) aus einer hinterlegten Logik sowie den gemessenen angeschlossenen Sensoren und Logikeingängen bestimmt. Diese Einheit sollte noch durch eine USV oder vergleichbares gestützt sein, da gerade im Falle eines Stromausfalles die Steuerung besonders wichtig ist.

Im Normalbetrieb wird das Elektroventil geschlossen sobald das System kalt ist. Dies verhindert, dass Druckschwankungen an der Hochdruckseite ständig Heliumgas ins Volumengefäß 8 eingepresst und wieder ausgesaugt wird, und so die bereits oben erwähnte zusätzliche Wärmelast entsteht. Mit geschlossenem Elektroventil funktioniert das Kühlersystem (Kaltkopf 4 und Kompressor 6) völlig separat vom eingeschlossenen Heliumvolumen.

Beim Stromausfall detektiert die elektronische Regeleinrichtung den Ausfall des Kompressors 6 und öffnet das Ventil, so dass Helium aus der Kammer bei typischerweise ca. 3-5 Kelvin abströmen kann. Die elektronische Regeleinrichtung misst die Temperatur T1 und öffnet ggf. das Elektroventil "dosiert", so dass nur so viel Kühlleistung generiert wird, wie tatsächlich gebraucht wird. Das verlängert die Autonomiezeit. So kann der Effekt kompensiert werden, dass die Abströmgeschwindigkeit von der verbleibenden Gasmenge im Reservoir abhängt, also am Anfang schneller abströmt als am Ende. Aus der Praxis weiß man, dass die erforderliche Kühlleistung eher den gegenteiligen zeitlichen Verlauf nimmt. Dieser Gegensatz kann z.B. durch Pulsweitenmodulation auf dem Auf-Zu-Ventil kompensiert werden.

Beim Recovery, d.h. wenn der Strom zurückkommt (Kompressor 6 springt wieder an, Kaltkopf 4 kühlt wieder) kann das Elektroventil benutzt werden, um die Kondensationsgeschwindigkeit frei zu wählen.

Bei der Fig. 4 gezeigten Ausführungsform der erfindungsgemäßen Anordnung ist das Auf-Zu-Ventil 13 der Ausführungsform nach Fig. 3 durch ein Regelventil 14 ersetzt. Dann kann auf das Drosselelement 12 verzichtet werden.

In weiteren Ausführungsformen werden nicht nur Druck und Temperatur, sondern auch der Massenfluss durch die Leitung 9 zum Volumengefäß 8 gemessen und zur Regelung des Ventils herangezogen.

Ein Haupt-Anwendungsgebiet der erfindungsgemäßen Kryostatanordnung ist der Einsatz in Magnetresonanzapparaturen. Dabei ist die Kryostatanordnung 1 zusammen mit der supraleitenden Magnetspule 3 Teil eines Magnetsystems, das eine Feldstärke zwischen 2 und 20 Tesla erzeugen kann, insbesondere als Teil einer NMR-, MRI- oder FTMS-Apparatur.

### Referenzliste:

Für die Beurteilung der Patentfähigkeit in Betracht gezogene Druckschriften
[1] EP 0 937 953 A1
[2] DE 199 14 778 B4
[3] DE 10 2014 218 773 A1
[4] US 7,263,839 B2
[5] US-A 5,410,286
[6] WO-2016/038093 A1
[7] DE 10 2004 053 972 B3
[8[ DE 103 40 352 B4

### Bezugszeichenliste:

- 1: Kryostatanordnung
- 2: Vakuumbehälter
- 3: supraleitendes Magnetspulensystem
- 4: Kühlkopf
- 5: Kühlmittelkreislauf
- 6: Kompressor
- 7: Kühlarm
- 8: Volumengefäß
- 9: druckfeste Leitung
- 10: strömungstechnisches Bauelement
- 12: Drosselelement
- 13: Auf-Zu-Ventil
- 14: Regelventil
- 15: elektronische Regeleinrichtung
- 16: unterbrechungsfreie Stromversorgung
- 17: Durchfluss-Sensor
- 18: Temperatur-Sensor
- 19: Druck-Sensor
- 20: Rohrwendel
- 21: Wärmetauscher
- 22: Strahlungsschild
- 24: Bypass-Drossel
- 25: Puffervolumen
- 26: Saugleitung
- 28: Sicherheitsventil
- 29: Aufnahmerohr des Kryokühlers

## Patentansprüche

1. Kryostatanordnung (1) mit einem Vakuumbehälter (2), in welchem ein zu kühlendes supraleitendes Magnetspulensystem (3) angeordnet ist, wobei ein Kryokühler vorhanden ist, der die Kryostatanordnung (1) aktiv kühlt und einen Kühlmittelkreislauf (5) mit einem Kompressor (6) sowie einen Kühlkopf (4) umfasst, welcher einen mindestens einstufigen, insbesondere zweistufigen Kühlarm (7) aufweist, der in thermischem Kontakt mit dem supraleitenden Magnetspulensystem (3) steht, wobei ein Volumengefäß (8) mit kryogenem Medium, insbesondere mit Helium, so angeordnet ist, dass es thermisch leitend mit dem supraleitenden Magnetspulensystem (3) und mit Teilen der Kryostatanordnung (1) verbunden ist, über welche Umgebungswärme auf das supraleitende Magnetspulensystem fließen kann,
**dadurch gekennzeichnet,**
**dass** das Volumengefäß (8) zwischen 0,5 und 5 Liter fasst,
**dass** das Volumengefäß (8) über eine druckfeste Leitung (9), die zumindest teilweise durch den Vakuumbehälter (2) geführt ist, mit dem Kühlmittelkreislauf (5) des Kryokühlers verbunden ist,
**dass** in der druckfesten Leitung (9) mindestens ein strömungstechnisches Bauelement (10), welches ein Drosselelement (12), ein Auf-Zu-Ventil (13) oder ein Regelventil (14) umfasst, angeordnet ist, mittels welchem die Durchflussmenge an kryogenem Medium durch die druckfeste Leitung (9) definiert beeinflusst werden kann,
und **dass** das strömungstechnische Bauelement (10) derart ausgestaltet ist, dass es die Durchflussmenge des durch eine Druckdifferenz zwischen dem Volumengefäß (8) und dem Kühlmittelkreislauf (5) des Kryokühlers hervorgerufenen Volumenstroms derart beeinflusst, dass entweder das kryogene Medium aus dem Kühlmittelkreislauf (5) des Kryokühlers das Volumengefäß (8) mit einer Zeitkonstanten von mindestens 15min befüllt oder dass das kryogene Medium aus dem Volumengefäß (8) mit einer Zeitkonstanten von mindestens 15min in den Kühlmittelkreislauf (5) des Kryokühlers abströmt.

2. Kryostatanordnung nach Anspruch 1, **dadurch gekennzeichnet, dass** das strömungstechnische Bauelement (10) derart aufgebaut und so angeordnet ist, dass die Zeitkonstante für das Befüllen oder das Entleeren des Volumengefäßes (8) mindestens 1h, vorzugsweise mehr als 3h beträgt.

3. Kryostatanordnung nach Anspruch 1 oder 2, **dadurch gekennzeichnet, dass** die Kryostatanordnung (1) Temperatursensoren (18) und/oder Drucksensoren (19) umfasst.

4. Kryostatanordnung nach einem der vorhergehenden Ansprüche, **dadurch gekennzeichnet, dass** das strömungstechnische Bauelement (10) ein passives Drosselelement (12) umfasst.

5. Kryostatanordnung nach Anspruch 3, **dadurch gekennzeichnet, dass** das strömungstechnische Bauelement (10) ein Auf-Zu-Ventil (13) und eine elektronische Regeleinrichtung (15) für dieses Auf-Zu-Ventil (13) umfasst, wobei die Ausgangssignale der Temperatur- (18) und/ oder Drucksensoren (19) zur Regelung des Auf-Zu-Ventils (13) verwendet werden.

6. Kryostatanordnung nach Anspruch 3, **dadurch gekennzeichnet, dass** das strömungstechnische Bauelement (10) ein Regelventil (14) und eine elektronische Regeleinrichtung (15) für das Regelventil (14) umfasst, wobei die Ausgangssignale der Temperatur- (18) und/ oder Drucksensoren (19) zur Regelung des Regelventils (14) verwendet werden.

7. Kryostatanordnung nach Anspruch 5 oder 6, **dadurch gekennzeichnet, dass** die elektronische Regeleinrichtung (15) an eine unterbrechungsfreie Stromversorgung (16) angeschlossen ist.

8. Kryostatanordnung nach einem der vorhergehenden Ansprüche, **dadurch gekennzeichnet, dass** die druckfeste Leitung (9) derart aufgebaut und so angeordnet ist, dass sie einen Wärmeaustausch des aus dem Volumengefäß (8) in den Kühlmittelkreislauf (5) des Kryokühlers abströmenden kryogenen Mediums mit Teilen des Kryostaten ermöglicht, über die ein Wärmeeintrag in das supraleitende Magnetspulensystem (3) erfolgt, insbesondere mit dem Kühlkopf (4) des Kryokühlers.

9. Kryostatanordnung nach Anspruch 8, **dadurch gekennzeichnet, dass** die druckfeste Leitung (9) eine Rohrwendel (20) umfasst, welche zumindest um Teile des Kühlarms (7) herum angeordnet ist.

10. Kryostatenanordnung nach Anspruch 8 oder 9, **dadurch gekennzeichnet, dass** das zu kühlende supraleitende Spulensystem (3) innerhalb des Vakuumbehälters (2) von einem Strahlungsschild (22) umgeben ist, und dass die druckfeste Leitung (9) mindestens einen Wärmetauscher (21) umfasst, der mit dem Strahlungsschild (22) und/ oder mit einer Stufe des Kühlarms (7) in thermischem Kontakt steht.

11. Kryostatanordnung nach einem der vorhergehenden Ansprüche, **dadurch gekennzeichnet, dass** strömungstechnisch parallel zum Kompressor (6) eine Bypass-Drossel (24) geschaltet ist.

12. Kryostatanordnung nach einem der vorhergehenden Ansprüche, **dadurch gekennzeichnet, dass** das Volumengefäß (8) 1 bis 2 Liter fasst.

13. Kryostatanordnung nach einem der vorhergehenden Ansprüche, **dadurch gekennzeichnet, dass** ein Puffervolumen (25), vorzugsweise mit einer Größe von etwa 100 Liter, im Kühlmittelkreislauf (5) des Kryokühlers, insbesondere in einer Saugleitung (26) zwischen dem Kühlkopf (4) und dem Kompressor (6), angeordnet ist.

14. Kryostatanordnung nach einem der vorhergehenden Ansprüche, **dadurch gekennzeichnet, dass** die Kryostatanordnung (1) zusammen mit der supraleitenden Magnetspule (3) Teil eines Magnetsystems ist, das eine Feldstärke zwischen 2 und 20 Tesla erzeugen kann, insbesondere als Teil einer NMR-, MRI- oder FTMS-Apparatur.

15. Verfahren zum Betrieb einer Kryostatanordnung (1) nach einem der vorhergehenden Ansprüche, bei welcher mindestens eine Vorrichtung zur Messung des aktuellen Betriebszustands des Kompressors (6) und/oder der aktuellen Temperatur (18) des supraleitenden Magnetspulensystems (3) und/oder des aktuellen Drucks (19) in der zum Volumengefäß (8) führenden druckfesten Leitung (9) vorhanden ist, wobei das strömungstechnische Bauelement (10) mit einer elektronischen Regeleinrichtung (15) verbunden ist,
**dadurch gekennzeichnet,**
**dass** die elektronischen Regeleinrichtung (15) bei einer -insbesondere durch Stromausfall hervorgerufenen- Betriebsstörung des Kompressors (6) des Kühlmittelkreislaufs (5) und/oder bei einem Anstieg der aktuellen Temperatur des supraleitenden Magnetspulensystems (3) während des Betriebs über eine festgelegte Maximaltemperatur und/oder bei einem Anstieg des aktuellen Drucks in der zum Volumengefäß (8) führenden druckfesten Leitung (9) über einen festgelegten Maximaldruck das strömungstechnische Bauelement (10) derart ansteuert, dass kryogenes Medium aus dem Volumengefäß (8) in den Kühlmittelkreislauf (9) des Kryokühlers abströmt.

## Claims

1. Cryostat arrangement (1) comprising a vacuum tank (2) in which a superconducting magnet coil system (3) to be cooled is arranged, a cryocooler being provided which actively cools the cryostat arrangement (1) and comprises a coolant circuit (5) comprising a compressor (6) and a cold head (4), which has an at least single-stage, in particular dual-stage cold finger (7) that is in thermal contact with the superconducting magnet coil system (3), a volumetric vessel (8) containing cryogenic fluid, in particular containing helium, being arranged such that it is thermally conductively connected to the superconducting magnet coil system (3) and to parts of the cryostat arrangement (1) via which ambient heat can flow to the superconducting magnet coil system,
**characterized in that**
the volumetric vessel (8) holds between 0.5 and 5 liters,
**in that** the volumetric vessel (8) is connected to the coolant circuit (5) of the cryocooler by means of a pressure-resistant line (9) that is guided through the vacuum tank (2) at least in part,
**in that** at least one fluidic component (10), which may comprise a throttle element (12), an on-off valve (13) or a regulating valve (14), is arranged in the pressure-resistant line (9), by means of which the flow rate of cryogenic fluid through the pressure-resistant line (9) can be influenced in a defined manner,
and **in that** the fluidic component (10) is designed such that it influences the flow rate of the volume flow brought about by a pressure differential between the volumetric vessel (8) and the coolant circuit (5) of the cryocooler such that either the volumetric vessel (8) is filled with cryogenic fluid from the coolant circuit (5) of the cryocooler with a time constant of at least 15 min or the cryogenic fluid flows out of the volumetric vessel (8) into the coolant circuit (5) of the cryocooler with a time constant of at least 15 min.

2. Cryostat arrangement according to claim 1, **characterized in that** the fluidic component (10) is constructed and arranged such that the time constant for filling or emptying the volumetric vessel (8) is at least 1 hour, preferably more than 3 hours.

3. Cryostat arrangement according to either claim 1 or claim 2, **characterized in that** the cryostat arrangement (1) comprises temperature sensors (18) and/or pressure sensors (19).

4. Cryostat arrangement according to any of the preceding claims, **characterized in that** the fluidic component (10) comprises a passive throttle element (12).

5. Cryostat arrangement according to claim 3, **characterized in that** the fluidic component (10) comprises an on-off valve (13) and an electronic control apparatus (15) for this on-off valve (13), the output signals from the temperature sensors (18) and/or pressure sensors (19) being used to regulate the on-off valve (13).

6. Cryostat arrangement according to claim 3, **characterized in that** the fluidic component (10) comprises a regulating valve (14) and an electronic control apparatus (15) for the regulating valve (14), the output signals from the temperature sensors (18) and/or pressure sensors (19) being used for regulating the regulating valve (14).

7. Cryostat arrangement according to either claim 5 or claim 6, **characterized in that** the electronic control apparatus (15) is connected to an uninterruptible power supply (16).

8. Cryostat arrangement according to any of the preceding claims, **characterized in that** the pressure-resistant line (9) is constructed and arranged such that it allows the cryogenic fluid flowing out of the volumetric vessel (8) into the coolant circuit (5) of the cryocooler to exchange heat with parts of the cryostat via which heat flows into the superconducting magnet coil system (3), in particular with the cold head (4) of the cryocooler.

9. Cryostat arrangement according to claim 8, **characterized in that** the pressure-resistant line (9) comprises a coiled tube (20) arranged at least around parts of the cold finger (7).

10. Cryostat arrangement according to either claim 8 or claim 9, **characterized in that** the superconducting coil system (3) to be cooled is surrounded by a radiation shield (22) within the vacuum tank (2), and **in that** the pressure-resistant line (9) comprises at least one heat exchanger (21), which is in thermal contact with the radiation shield (22) and/or with a stage of the cold finger (7).

11. Cryostat arrangement according to any of the preceding claims, **characterized in that** a bypass throttle (24) is fluidically connected in parallel with the compressor (6).

12. Cryostat arrangement according to any of the preceding claims, **characterized in that** the volumetric vessel (8) holds 1 to 2 liters.

13. Cryostat arrangement according to any of the preceding claims, **characterized in that** a buffer volume (25), preferably having a magnitude of approximately 100 liters, is arranged in the coolant circuit (5) of the cryocooler, in particular in a suction line (26) between the cold head (4) and the compressor (6).

14. Cryostat arrangement according to any of the preceding claims, **characterized in that**, together with the superconducting magnet coil (3), the cryostat arrangement (1) is part of a magnet system which can generate a field strength of between 2 and 20 Tesla, in particular as part of an NMR, MRI or FTMS apparatus.

15. Method for operating a cryostat arrangement (1) according to any of the preceding claims, in which at least one device is provided for measuring the current operating state of the compressor (6) and/or the current temperature (18) of the superconducting magnet coil system (3) and/or the current pressure (19) in the pressure-resistant line (9) leading to the volumetric vessel (8), the fluidic component (10) being connected to an electronic control apparatus (15),
**characterized in that**,
in the event of an operational malfunction of the compressor (6) of the coolant circuit (5), in particular caused by a power outage, and/or in the event of the current temperature of the super conducting magnet coil system (3) increasing during operation above a set maximum temperature and/or in the event of the current pressure in the pressure-resistant line (9) leading to the volumetric vessel (8) increasing above a set maximum pressure, the electronic control apparatus (15) actuates the fluidic component (10) such that cryogenic fluid flows out of the volumetric vessel (8) into the coolant circuit (9) of the cryocooler.

## Revendications

1. Agencement de cryostat (1) comportant une enceinte sous vide (2) dans laquelle est disposé un système de bobine magnétique supraconductrice (3) à refroidir, un cryorefroidisseur qui refroidit activement l'agencement de cryostat (1) et qui comprend un circuit de refroidissement (5) comportant un compresseur (6) ainsi qu'une tête de refroidissement (4), laquelle présente un bras de refroidissement (7) à au moins un étage, en particulier à deux étages, qui est en contact thermique avec le système de bobine magnétique supraconductrice (3), un récipient volumétrique (8) contenant un milieu cryogénique, en particulier de l'hélium, étant disposé de manière à être en conduction thermique avec le système de bobine magnétique supraconductrice (3) et avec des parties de l'agencement de cryostat (1), par lequel la chaleur ambiante peut s'écouler sur le système de bobine magnétique supraconductrice,
**caractérisé en ce**
**que** le récipient volumétrique (8) contient entre 0,5 et 5 litres,
**que** le récipient volumétrique (8) est relié au circuit de refroidissement (5) du cryorefroidisseur par une conduite résistante à la pression (9) qui passe au moins partiellement à travers l'enceinte sous vide (2),
**qu'**au moins un composant de technique des fluides (10), qui comprend un élément d'étranglement (12), une vanne d'ouverture/fermeture (13) ou une vanne de régulation (14), est disposé dans la conduite résistante à la pression (9), au moyen duquel le débit de milieu cryogénique peut être influencé de manière définie par la conduite résistante à la pression (9),
et **que** le composant de technique des fluides (10) est conçu de telle sorte qu'il influence le débit du flux volumique provoqué par une différence de pression entre le récipient volumétrique (8) et le circuit de refroidissement (5) du cryorefroidisseur de telle sorte que soit le milieu cryogénique provenant du circuit de refroidissement (5) du cryorefroidisseur remplit le récipient volumétrique (8) avec une constante de temps d'au moins 15 minutes, soit le milieu cryogénique s'écoule du récipient volumétrique (8) dans le circuit de refroidissement (5) du cryorefroidisseur avec une constante de temps d'au moins 15 minutes.

2. Agencement de cryostat selon la revendication 1, **caractérisé en ce que** le composant de technique des fluides (10) est réalisé et disposé de telle sorte que la constante de temps pour le remplissage ou la vidange du récipient volumétrique (8) est d'au moins 1 heure, de préférence de plus de 3 heures.

3. Agencement de cryostat selon la revendication 1 ou 2, **caractérisé en ce que** l'agencement de cryostat (1) comprend des capteurs de température (18) et/ou des capteurs de pression (19).

4. Agencement de cryostat selon l'une des revendications précédentes, **caractérisé en ce que** le composant de technique des fluides (10) comprend un élément d'étranglement passif (12).

5. Agencement de cryostat selon la revendication 3, **caractérisé en ce que** le composant de technique des fluides (10) comprend une vanne d'ouverture/fermeture (13) et un moyen de régulation électronique (15) pour cette vanne d'ouverture/fermeture (13), les signaux de sortie des capteurs de température (18) et/ou de pression (19) étant utilisés pour réguler la vanne d'ouverture/fermeture (13).

6. Agencement de cryostat selon la revendication 3, **caractérisé en ce que** le composant de technique des fluides (10) comprend une vanne de régulation (14) et un moyen de régulation électronique (15) pour la vanne de régulation (14), les signaux de sortie des capteurs de température (18) et/ou de pression (19) étant utilisés pour réguler la vanne de régulation (14).

7. Agencement de cryostat selon la revendication 5 ou 6, **caractérisé en ce que** le moyen de régulation électronique (15) est relié à une alimentation sans coupure (16).

8. Agencement de cryostat selon l'une des revendications précédentes, **caractérisé en ce que** la conduite résistante à la pression (9) est réalisée et disposée de manière à permettre un échange de chaleur du milieu cryogénique s'écoulant du récipient volumétrique (8) dans le circuit de refroidissement (5) du cryorefroidisseur avec des parties du cryostat par lesquelles un apport de chaleur a lieu dans le système de bobine magnétique supraconductrice (3), en particulier avec la tête de refroidissement (4) du cryorefroidisseur.

9. Agencement de cryostat selon la revendication 8, **caractérisé en ce que** la conduite résistante à la pression (9) comprend un serpentin (20) qui est disposé au moins autour de parties du bras de refroidissement (7).

10. Agencement de cryostat selon la revendication 8 ou 9, **caractérisé en ce que** le système de bobine supraconductrice (3) à refroidir est entouré à l'intérieur de l'enceinte sous vide (2) par un écran anti-rayonnement (22), et que la conduite résistante à la pression (9) comprend au moins un échangeur de chaleur (21) qui est en contact thermique avec l'écran anti-rayonnement (22) et/ou avec un étage du bras de refroidissement (7).

11. Agencement de cryostat selon l'une des revendications précédentes, **caractérisé en ce qu'**un étranglement de dérivation (24) est monté fluidiquement en parallèle avec le compresseur (6).

12. Agencement de cryostat selon l'une des revendications précédentes, **caractérisé en ce que** le récipient volumétrique (8) a une contenance de 1 à 2 litres.

13. Agencement de cryostat selon l'une des revendications précédentes, **caractérisé en ce qu'**un volume tampon (25), de préférence d'environ 100 litres, est disposé dans le circuit de refroidissement (5) du cryorefroidisseur, en particulier dans une conduite d'aspiration (26) entre la tête de refroidissement (4) et le compresseur (6).

14. Agencement de cryostat selon l'une des revendications précédentes, **caractérisé en ce que** l'agencement de cryostat (1) avec la bobine magnétique supraconductrice (3) fait partie d'un système magnétique capable de générer une intensité de champ comprise entre 2 et 20 teslas, en particulier en tant que partie d'un appareil de RMN, d'IRM ou de FTMS.

15. Procédé de fonctionnement d'un agencement de cryostat (1) selon l'une des revendications précédentes, dans lequel au moins un dispositif de mesure de l'état de fonctionnement actuel du compresseur (6) et/ou de la température actuelle (18) du système de bobine magnétique supraconductrice (3) et/ou de la pression actuelle (19) dans la conduite résistante à la pression (9) menant au récipient volumétrique (8) est présent, le composant de technique des fluides (10) étant relié à un moyen de régulation électronique (15),
**caractérisé en ce**
**que** le moyen de régulation électronique (15) commande le composant de technique des fluides (10) de telle sorte qu'en cas de défaut de fonctionnement - en particulier provoqué par une panne de courant - du compresseur (6) du circuit de refroidissement (5) et/ou en cas d'augmentation de la température actuelle du système de bobine magnétique supraconductrice (3) pendant le fonctionnement au-dessus d'une température maximale définie et/ou en cas d'augmentation de la pression actuelle dans la conduite résistante à la pression (9) menant au récipient volumétrique (8) au-dessus d'une pression maximale définie, du milieu cryogénique s'écoule du récipient volumétrique (8) dans le circuit de refroidissement (9) du cryorefroidisseur.
